# EUROPÄISCHE PATENTSCHRIFT

(11) **EP 1 759 247 B1**
(45) Veröffentlichungstag und Bekanntmachung des Hinweises auf die Patenterteilung: **13.06.2012**
(21) Anmeldenummer: 05729131.2
(22) Anmeldetag: 08.03.2005
(51) Int. Cl.: G03F 7/20

(54) **VERFAHREN ZUR ELEKTROSTATISCHEN STRUKTURIERUNG EINER SUBSTRATOBERFLÄCHE UND RASTERSONDEN-LITHOGRAPHIEVERFAHREN DAMIT**
METHOD FOR THE ELECTROSTATIC STRUCTURING OF A SUBSTRATE SURFACE AND RASTER PROBE LITHOGRAPHY METHOD
PROCEDE DE STRUCTURATION ELECTROSTATIQUE D'UNE SURFACE DE SUBSTRAT ET PROCEDE LITHOGRAPHIQUE A SONDES A BALAYAGE

(30) Priorität: 10.03.2004 DE 102004012179
(43) Veröffentlichungstag der Anmeldung: 07.03.2007
(73) Patentinhaber: Universität Kassel, 34125 Kassel (DE)
(72) Erfinder: RANGELOW, Ivo, 34225 Baunatal (DE); PEDRAK, Robert, PL-57-402 Nowa Ruba (PL); IVANOV, Tzvetan, 98693 Ilmenau (DE)
(74) Vertreter: Dantz, Jan Henning
(86) Internationale Anmeldenummer: PCT/DE2005/000425
(87) Internationale Veröffentlichungsnummer: WO 2005/088399

(56) Entgegenhaltungen:
- US-A- 4 896 044
- US-A- 5 618 760
- US-A- 5 666 190
- US-A- 5 702 620
- US-A- 6 042 993
- US-A1- 2003 020 025
- MAOZ R ET AL: "CONSTRUCTIVE NANOLITHOGRAPHY: INERT MONOLAYERS AS PATTERNABLE TEMPLATES FOR IN-SITU NANOFABRICATION OF METAL-SEMICONDUCTOR-ORGANIC SURFACE STRUCTURES - A GENERIC APPROACH" ADVANCED MATERIALS, VCH VERLAGSGESELLSCHAFT, WEINHEIM, DE, Bd. 12, Nr. 10, 17. Mai 2000 (2000-05-17), Seiten 725-731, XP000958769 ISSN: 0935-9648
- BONFIGLIO A ET AL: "CONTROLLED ABLATION OF LANGMUIR-BLODGETT FILMS MADE BY SCANNING FORCE MICROSCOPY" ADVANCED MATERIALS FOR OPTICS AND ELECTRONICS, WILEY AND SONS LTD, CHICHESTER, GB, Bd. 7, Nr. 3, Mai 1997 (1997-05), Seiten 141-148, XP000703966 ISSN: 1057-9257
- FAULL J D ET AL: "Ionic interactions and multilayer structures on self-assembled surfaces of calix[4]resorcinarene" PREPARATION AND CHARACTERIZATION, ELSEVIER SEQUOIA, NL, Bd. 457, Nr. 2, 15. Juni 2004 (2004-06-15), Seiten 292-300, XP004507228 ISSN: 0040-6090

## Beschreibung

Die Erfindung betrifft ein Verfahren zur elektrostatischen Strukturierung einer Substratoberfläche gemäß dem Oberbegriff des Anspruchs 1 und ein Rastersonden-Lithographieverfahren damit.

Derartige Verfahren werden u.a. bei der Herstellung von Halbleiterbauelementen neben anderen bzw. ergänzend zu anderen bekannten Oberflächenstrukturterungsverfahren wie Lithographie mit Elektronen- und Röntgenstrahlen und der Photolithographie eingesetzt.

Neben den letztgenannten Lithographie-Verfahren werden insbesondere im Bereich von Nanostrukturen Verfahren der Raster-Sonden-Elektronenstrahl Lithographie zunehmend zur Strukturierung von Oberflächen eingesetzt. Bei dieser Art der Lithographie wird ein Elektronenstrahl aus einer mit einer elektrischen Spannung beaufschlagten Spitze an einem Biegebalken eines atomaren Kraftmikroskops - Atomic Force Microscope (AFM) - über eine Feldmission ausgestrahlt. Eine unter dem Kraftmikroskop befindliche Substratoberfläche ist mit einem Lack versehen, welcher gegenüber den Elektronenstrahlen empfindlich ist. Der Bereich bzw. Bahn, über welche die Spitze des Kraftmikroskops bewegt wird, wird mit Elektronen belichtet und dabei chemisch modifiziert. Als Resistmaterialien werden bei dieser insbesondere zur Erzeugung von Strukturen im Sub-50-Nanometerbereich eingesetzten Lithographieart Polymere unterschiedlicher Zusammensetzung verwendet. Als Resistmaterialien bei der Raster-Sonden-Elektronenstrahllithographie sind u.a. auch Calixarene eingesetzt worden.

Calixarene sind [1ₙ]-Metacyclophane, die durch Cyklokondensation von Phenolen und Formaldehyd einfach erhältlich sind. Ihr Name ergibt sich aus der kelchförmigen Gestalt des einfachsten Vertreters der Calixarene, dem Calix[4]aren in Verbindung mit dem griechischen Wort Calix, welches für Tasse, Vase oder Kelch bedeutet. Calixarene weisen eine Fähigkeit auf, neutrale organische Moleküle oder Ionen komplexieren zu können. Sie werden insbesondere als selektive Liganden in der analytischen Chemie, in der Sensortechnik, in der medizinischen Diagnostik sowie bei der Aufarbeitung nuklearer Abfälle und als Mimetika für Enzyme eingesetzt, siehe A. Casnati, "Calixarenes: From chemical curiosity to a rich souce for molecular receptors", Gazz. Chim. Ital. 127, 637 - 649 (1997).

Aus dem US-Patent 5,702,620 ein Verfahren zur ultrafeinen Strukturierung und ein ultrafeines Ätzvertahren unter Benutzung eines Calixarenderivats als Negativresist bekannt geworden. Hierbei wird ein Resistfilm aus 5, 11, 17, 23, 29, 35-Hexachloromethyl-37, 38, 39, 40, 41, 42-Hexamethoxycalix [6]aren, der für hochenergetische Strahlen empfindlich ist und in einem Lösungsmittel löslich ist, auf einem durch Trockenätzen ätzbaren Substrat gebildet. Ein Teil des Filmes wird dabei einem hochenergetischen Elektronenstrahl aus einem in der Mikrostrukturtechnik üblichen Elektronenstrahlschreiber mit Beschleunigungsspannungen von beispielsweise 30-50kV ausgesetzt. Ein anderer nicht dieser Strahlung ausgesetzter Bereich wird durch das Lösungsmittel entfernt, so daß der bestrahlte und entwickelte Bereich eine Strukturierung des Substrates definiert. Das Substrat kann dann anschließend mit einem Trockenätzverfahren weiter behandelt werden.

Auch ist die Verwendung von Calixaren-Derivaten und Calixresorzinaren-Derivaten als positives Photoresist-Material aus der japanischen Patentanmeldung JP 101 465 97 bekannt geworden.

Ein Verfahren der eingangs genannten Gattung ist die sogenannte, aus Nature Materials Bd. 2, 468, 2003 bekannte elektrostatische Nanolithographie von Polymeren unter Benutzung eines atomaren Kraftmikroskops (AFMEN). Dieses AFMEN-Lithographieverfahren ist in der Lage, Strukturen von Breiten von 1- 50 nm dadurch zu erzeugen, daß eine hochleitende Wolframspitze eines atomaren Kraftmikroskops (AFM) über einen Polymerfilm mit einer Schichtdicke von 20 bis 100 nm und einer Oberflächenrauhigkeit von 0,5 bis 1 nm gefahren wird. Dabei ist der als Polymethylmetacrylat (PMM) ausgeführte Polymerfilm auf einer geerdeten Leiterschicht, einem Au-Pd-Film auf einem Silizium-Wafer aufgebracht. Wird die Cantileverspitze in einem Abstand von wenigen Nanometern über den Polymerfilm gebracht und eine Spannung angelegt, so herrscht aufgrund der Spitzengeometrie an der Spitze eine Feldstärke im Bereich von 10⁸ - 10¹⁰ V/m, wobei jedoch eigentlich ein starker Abfall der Feldstärke zu beobachten ist. Eine Elektronenemission von der Spitze führt zu einem meßbaren Stromfluß durch das Polymer, so daß nach Modellrechnungen die Temperatur im direkt unter der Spitze liegenden Bereich des Polymers über der GlasÜbergangstemperatur T_{g} liegt und sich eine lokalisierte Zone einer dielektrischen und viskoelastischen Flüssigkeit bildet.

Bei diesem Verfahren wird ein Polymethylmetacrylatfilm abgetragen bzw. strukturiert. Dieser Film ist ein Polymerfilm, bei dem Monomere zu kettenartig ausgebildeten Makromolekülen verbunden sind. Entlang der Ketten sind die Monomere über kovalente Bindungen stabil miteinander verbunden. Zusätzlich kann die Stabilität des Polymers durch Vernetzung und auch Bindungen zwischen einzelnen Ketten erhöht sein. Dadurch ist es nahezu unmöglich, einzelne Monomere bzw. kleine Gruppen davon aus dem Polymer herauszulösen.

Da die Bindungsenergie der Moleküle innerhalb des Polymers auf Grund der stabilen Kettenmoleküle relativ groß ist, kann mit Hilfe der elektrostatischen Lithograpie eine Materialabtragung nicht ohne weiteres erfolgen. So ist eine lokale Überführung des Polymers in einen schmelz- bzw. glasartigen Zustand mit schwächerer Bindungsenergie notwendig, um über elektrostatische Kräfte ein Abtragen der Schicht zu erreichen.

Da die Bindungsenergie in dieser viskoelastischen Schmelzzone schwächer ist als in dem nicht aufgeschmolzenen Restbereich des Polymers mit intakten Ketten, ist in der Schmelzzone eine stärkere Polarisation durch die Spitze des atomaren Kraftmikroskops möglich. Durch das starke elektrische Feld wird der geschmolzene Bereich des Polymers unterhalb der Spitze von dieser derart angezogen, daß sich ein erhaben hervorstehender Bereich bildet. Dadurch ist eine Strukturierung im Submikrometerbereich der Polymeroberfläche erreicht worden. Schließlich können bei entsprechend hohen Spannungen in der Mitte der angehobenen geschmolzenen Bereiche des Polymers Löcher dadurch gebildet werden, daß von der Spitze Teile des Polymers elektrostatisch angezogen werden. Dabei Ist es möglich die Größe der Löcher bzw. die Tiefe der Löcher durch die benutzten Parameter von Spannung, Abstand und Verweildauer über dem Polymer zu verändern bzw. einzustellen. Es ist sogar möglich, die Polymerschicht lokal vollständig abzutragen und somit Substratbereiche freizulegen. Durch das einem Entfernen der Polymerschicht vorangehende Aufschmelzen ist die erreichbare Strukturbreite so erzielbarer Strukturen allerdings beschränkt. Zudem treten an den Seiten der erzeugten grabenartigen Strukturen störende Aufwölbungen auf.

Ähnliche Verfahren, bei denen eine einer Strukturierung eines Substrats auf einer nanometrischen Skala mittels einer Elektronenemission von der Spitze eines Rasterkraft- oder Tunnelmikroskops erfolgt, sind aus den Druckschriften US 5,666,190; US 4,896,044; US 5,618,760 und US 6,042,993 bekannt. Durch den von der Spitze zum Substrat erfolgenden Elektronenstrom können, wie zuvor beschrieben, Polymerschichten strukturiert werden, aber auch lokal chemische Reaktionen, wie zum Beispiel Oxidationen, induziert werden, die ebenfalls zur Strukturierung eingesetzt werden können. Auch kann durch ein lokales Aufheizen einer Substratoberfläche, das zu einer thermischen Desorption von Oberflächenatomen und- molekülen führt, eine unmittelbare Strukturierung vorgenommen werden.

Eine induzierte chemische Reaktion beschreibt auch der Artikel "Constructive Nanolithography", R. Maoz et al., Adv. Mater. 2000, 12, No. 10, am Beispiel einer Elektrooxidation von organischen selbstorganisierten Schichtstrukturen.

Schließlich sind Strukturierungsverfahren mit Raster-Kraftmikroskopen bekannt, die im Wesentlichen auf einer mechanischen Wechselwirkung zwischen der Spitze des Mikroskops und der Probe beruhen, z. B. aus der Druckschrift US 2003/0020025 A1 oder aus dem Artikel "Controlled Ablation of Langmuir-Blodgett Films Made by Scanning Force Microscopy", A. Bonfiglio et al., Adv. Mater. Opt. Electron. Vol 7, 1997.

Der Erfindung liegt die Aufgabe zugrunde, die eingangs genannten Verfahren so weiterzuentwickeln, daß scharf begrenzte Abtragsstrukturen bis hin zu Strukturbreiten von einigen Nanometern erreicht werden.

Die Aufgabe wird ausgehend von dem Oberbegriff des Anspruchs 1 mit dem kennzeichnenden Teil dieses Anspruchs sowie mit dem Verfahren nach Anspruch 21 gelöst.

Erfindungsgemäß wird eine Substratoberfläche durch Positionieren einer an einem Biegebalken eines atomaren Kraftmikroskops angebrachten Spitze über dem Substrat elektrostatisch strukturiert. Dabei wird zwischen dem Substrat und der Spitze eine elektrische Gleichspannung angelegt. Der Abstand der Spitze von dem Substrat und die Gleichspannung werden dabei so gewählt, daß in einem im wesentlichen unterhalb der Spitze befindlichen Bereich des Substrats Substratmaterial von der Spitze elektrostatisch angezogen wird, und das Substrat an der Substratoberfläche dadurch zumindest teilweise abgetragen wird. Das Verfahren zeichnet sich dadurch aus, daß ein Substrat mit einer Oberfläche verwendet wird, die von einer Deckschicht aus Molekülen mit einer kelchförmigen 3-dimensionalen Struktur gebildet ist, die untereinander im wesentlichen durch van der Waals-Kräfte gebunden sind, wobei als Deckschicht (3) ein Calixarene enthaltendes Material gewählt wird.

Erfindungsgemäß ist auch ein Rastersonden-Lithographieverfahren mit einer Oberflächenstrukturierung mit dem Verfahren zur elektrostatischen Strukturierung eines flächigen Substrates vorgesehen.

Mit Vorteil kann erfindungsgemäß ein Substrat an seiner Oberfläche abgetragen bzw. bis zu Strukturbreiten von einigen Nanometern strukturiert werden, ohne daß eine Schädigung des Substrates auftritt. Dadurch können ohne Zwischenschaltung von weiteren Behandlungen Prozeßschritte wie etwa ein Abtragen, ein Ätzschritt oder ein Lift-off-Schritt, angeschlossen werden. Ebenso kann eine an einer Substratoberfläche vorgesehene dünne Schicht sehr fein strukturiert werden. Das erfindungsgemäße Strukturierungsverfahren erfordert dabei keine vorangehende oder sonstige zusätzliche chemische oder physikalische Behandlung der Oberfläche bzw. des Substrates.

Weitere Vorteile ergeben sich aus den Unteransprüchen.

Im Rahmen der Erfindung umfaßt der Begriff Substrat auch einen substratartigen Grundkörper, das eigentliche Substrat, auf den weitere Schichten aufgebracht sind.

Somit ist ein mehrschichtiges Substrat umfaßt, dessen Oberfläche strukturiert wird. Dabei kann eine Schicht den Grundkörper bzw. weitere auf diesem aufgebrachte Substratschichten als Deckschicht bedecken. Diese die Oberfläche des Substrats bildende Deckschicht ist mit dem erfindungsgemäßen Verfahren auch für sich strukturier- bzw. zumindest teilweise abtragbar.

In einer Ausführung des erfindungsgemäßen Verfahrens wird eine auf einem Substrat befindliche dünne Deckschicht dadurch von dem Substrat abgelöst, daß eine entgegengesetzt zum Substrat elektrisch geladene Spitze eines Rasterkraftmikroskops in einem sehr geringen Abstand, also berührungsfrei, über die Deckschicht bewegt wird bzw. das Substrat bezüglich der Spitze bewegt wird. Dabei wird unterhalb der Spitze Material dieser Deckschicht durch eine von der Spitze ausgehende elektrostatische Anziehungskraft zumindest teilweise von dieser angezogen. Dabei werden einzelne Moleküle und/öder Gruppen von Molekülen herausgelöst, die eine begrenzte Ausdehnung aufweisen und mit Nachbarmolekülen und/oder mit dem Substrat im wesentlichen durch van der Waals-Kräfte gebunden sind. Erfindungsgemäß werden die Moleküle aus dem Deckschichtbereich mittels einer elektrostatischen Anziehungskraft herausgelöst, ohne daß die Deckschicht des Deckschichtbereichs zuvor einer Änderung ihres physikalischen Zustands, etwa in Form eines Übergangs in die flüssige Phase unterworfen wird.

Im Rahmen der Erfindung gemäß den Ansprüchen 1 und 19 werden als Deckschicht Materialien benutzt, die im Gegensatz zu Polymeren Moleküle mit räumlich stark begrenzter Ausdehnung aufweisen. Dadurch ist eine Erzeugung scharfer Abtragungsstrukturen auf Grund der begrenzten Molekülgröße und auf Grund deren schwacher Bindungen untereinander und zum Substrat möglich.

Erfindungsgemäß wird eine Deckschicht verwendet, die Calixarene enthält. Das Calixarene enthaltende Material ist elektrostatisch von dem Substrat zumindest teilweise durch Einwirkung eines elektrischen Feldes, das bevorzugt von einer Cantileverspitze eines Kraftfeldmikroskops ausgeht, entfernbar. Dabei wirkt das Calixaren enthaltende Material wie ein Positivresist etwa bei der Photolithographie.

Die Erfindung wird nachfolgend anhand eines Ausführungsbeispiels im Zusammenhang mit den begleitenden, in unterschiedlichen Maßstäben gehaltenen Zeichnungen näher erläutert. Dabei ist:
Fig. 1 eine schematische Prinzipskizze zum erfindungsgemäßen Verfahren,
Fig. 2 eine zwei- bzw. dreidimensionale Darstellung eines erfindungsgemäß bei der Erzeugung von strukturierten Oberflächen benutzten Materials aus Sabine Gebauer, Dissertation, Martin-Luther-Universität Halle-Wittenberg 1999,
Fign. 3a bis 3e eine vereinfachte Darstellung einer Oberflächenstrukturierung gemäß der Erfindung,
Fig. 4 eine rasterelektronmikroskopische Aufnahme einer mit dem erfindungsgemäßen Verfahren erzeugten Struktur und
Fig. 5 ein Diagramm, welches die Abhängigkeit der Linienbreite des Abtrags in Abhängigkeit von der Elektronendosis zeigt.

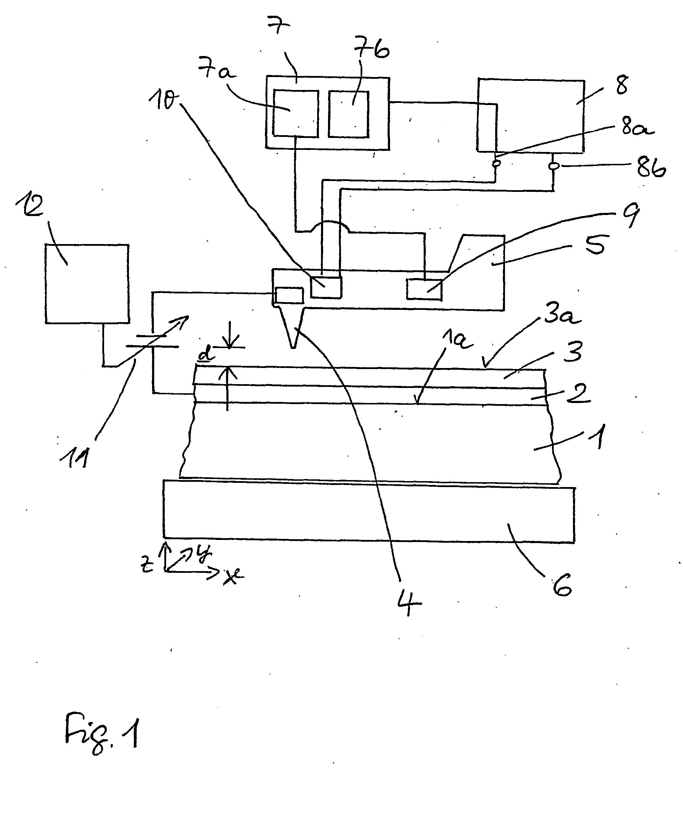

Fig. 1 stellt eine Anordnung zur Durchführung des erfindungsgemäßen Verfahren zur Strukturierung einer auf einem Substrat befindlichen Deckschicht bzw. auch des Substrats dar. Nach Fig. 1 befindet sich auf einem Substrat 1, das bevorzugt ein Siliziumwafer ist, eine elektrisch leitende Schicht 2, vorzugsweise eine Chrom-Gold-Schicht (CrAu-Schicht). Auf der CrAu-Schicht 2 ist eine filmartige Deckschicht 3 aus einem Calix[n]aren, n = 4 bis 8 aufgebracht. Über der Calixarenschicht 3 ist eine Spitze 4 eines Biegebalkens/Cantilevers 5 eines im Detail nicht weiter gezeigten atomaren Kraftmikroskops (AFM) in einem Abstand von 10 bis 100 Å, d.h. berührungsfrei im sogenannten "non-contact-mode" positioniert.

Nach Fig. 1 ist das Substrat 1 auf einem Scannertisch 6 vorgesehen. Der Scannertisch 6 ist dazu ausgebildet, das Substrat 1 in drei aufeinander senkrecht stehenden Raumrichtungen, d.h. in der in der Papierebene liegenden z-Richtung sowie in der dazu senkrechten Ebene (x-, y-Richtung) sehr genau relativ zur Spitze 4 des Cantilevers 5 zu bewegen. Eine Bewegung des Scannertisches 6 in z-Richtung entspricht dabei einer Veränderung des Abstands d von Spitze 4 und Substrat 1 bzw. Deckschicht 3. Bevorzugt wird der Scannertisch 6 benutzt, um einen ersten Arbeitsabstand zwischen Spitze 4 und Deckschicht 3 einzustellen.

Ferner sind in Fig. 1 eine Steuer- und Regelungseinheit 7, sowie eine Stromquelle 8 mit einem Gleichstrom- und einem Wechselstromausgang 8a, 8b schematisch angedeutet. In dem Cantilever 5 sind ein piezoresitiver Sensor 9 und ein Heizdrahtaktuator 10 eingebaut. Dem Heizdrahtaktuator 10 wird von dem Wechselstromausgang 8b der Stromquelle 8 ein Wechselstrom aufgeprägt, der ihn in periodische Schwingungen versetzt. Zusätzlich ist der Heizdrahtaktuator 10 an den Gleichstromausgang 8a angeschlossen. Wird dem Heizdrahtaktuator 10 ein Gleichstrom aufgeprägt so biegt sich der Cantilever 5 in z-Richtung und nähert sich der Oberfläche 3a an. Dabei wird der dem Heizdrahtaktuator 10 zugeführte Gleichstrom so gewählt, daß sich der Cantilever 5 der Oberfläche 3a soweit annähert, daß van der Waals-Kräfte wirksam werden, was im non-contact-Modus eines AFM ausgenutzt wird. Die dadurch gedämpften Schwingungen des Cantilevers 5 sind gegenüber der Anregungsfrequenz des Wechselstroms phasenverschoben. Die Phasenverschiebung zwischen dem Signal des Sensors 9 und des Wechselstroms der Stromquelle 8 wird einem Vergleicher 7a der Vergleichs- und Regelungseinheit 7 zugeführt. Der Regler 7b dieser Einheit 7 steuert den Gleichstromausgang 8a, um den Abstand von Cantilever 5 auf ein vorgegebenen Abstand einzustellen bzw. den Abstand konstant zu halten.

Zur genauen Beschreibung zur Einstellung und Steuerung des Abstands der Spitze 4 von dem Substrat 1 sowie zur Bewegung einer Cantileverspitze 4 in einem atomaren Kraftmikroskop wird u.a. auf die deutsche Patentanmeldung 103 07 561.5 verwiesen, deren vollständiger Offenbarungsgehalt in die vorliegende Anmeldung einbezogen wird.

Weiter ist die CrAu-Schicht 2 an einen Pluspol einer Spannungsquelle 11 gelegt. Der negative Ausgang dieser Spannungsquelle 11 ist über nicht gezeigte Zuleitungen an einen Kontaktabschnitt 12 nahe der Spitze 4 des Cantilevers 5 angeschlossen. So bildet das System Spitze 4 und CrAu-Schicht 3 im wesentlichen einen Kondensator. Dabei kommt der Deckschicht 3 die Rolle eines Dielektrikums zu. Die Ausgangsspannung der Spannungsquelle 11 ist über eine damit verbundene Meß- und Regeleinheit 12 variier- bzw. einstellbar.

Das erfindungsgemäße Verfahren wird wie folgt durchgeführt. Es wird die Calixarenschicht 3 in einem Vakuum mit einem Druck von 10⁻⁶ Torr auf einen mit einer CrAu-Schicht 2 versehenen Siliziumwafer 1 aufgedampft. Die CrAu-Schicht 2 wird ebenfalls zuvor auf den Siliziumwafer aufgedampft, wobei auf die Siliziumoberfläche 1a zunächst eine 10 bis 20 nm dicke Schicht aus Cr und darauf eine 30 bis 50 Nanometer dicke Au-Schicht aufgedampft wird. Der mit der Metallisierungsschicht 2 versehene Siliziumwafer 1 wird in einer nicht dargestellten Aufdampfanlage einem Tantalschiffchen in einem Abstand von 10 bis 15 cm gegenüberliegend positioniert. Dabei wird der Siliziumwafer 1 entweder auf einen Haltering gelegt oder an einer Haltevorrichtung über den Siliziumwafer 1 am Rand umfassenden Klammern festgelegt. Das Tantalschiffchen wird durch Durchleitung eines Stromes von 5 bis 10 A auf Temperaturen von 150 bis 250°C erhitzt wobei sich in der Mulde des Tantalschiffchen befindliches Calix[4]arenpulver mit einer Masse von etwa 1 mg aufgeschmolzen und homogen auf die Metallisierungsschicht 2 der Siliziumwafers 1 aufgedampft wird. Vorzugsweise wird die Schichtdickenmessung mit einer Meßgenauigkeit von 1 bis 2 nm dabei mit einem in der Aufdampfanlage neben dem Siliziumwafer über dem Tantalschiffchen positionierten Schwingquarz durch eine Frequenzverschiebung ermittelt. Die so in der Aufdampfanlage aufgebrachte Schichtdicke der Calixarenschicht 3 beträgt etwa 10 bis 100 nm. Der so mit der Calixarenschicht 3 versehene Siliziumwafer 1 wird nun, wie in Fig. 1 schematisch dargestellt, in ein atomares Kraftmikroskop (AFM) eingebracht.

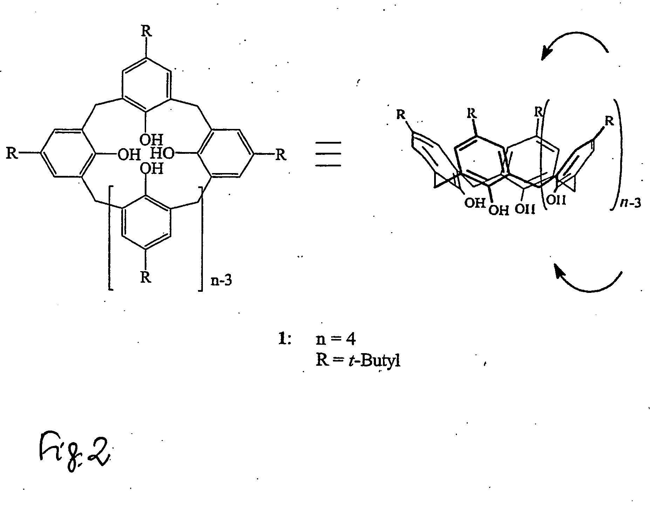

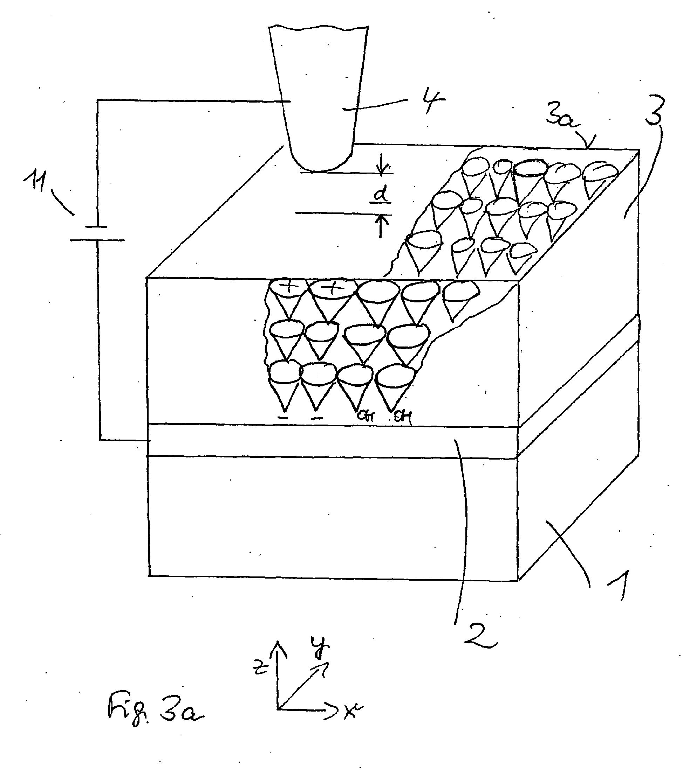

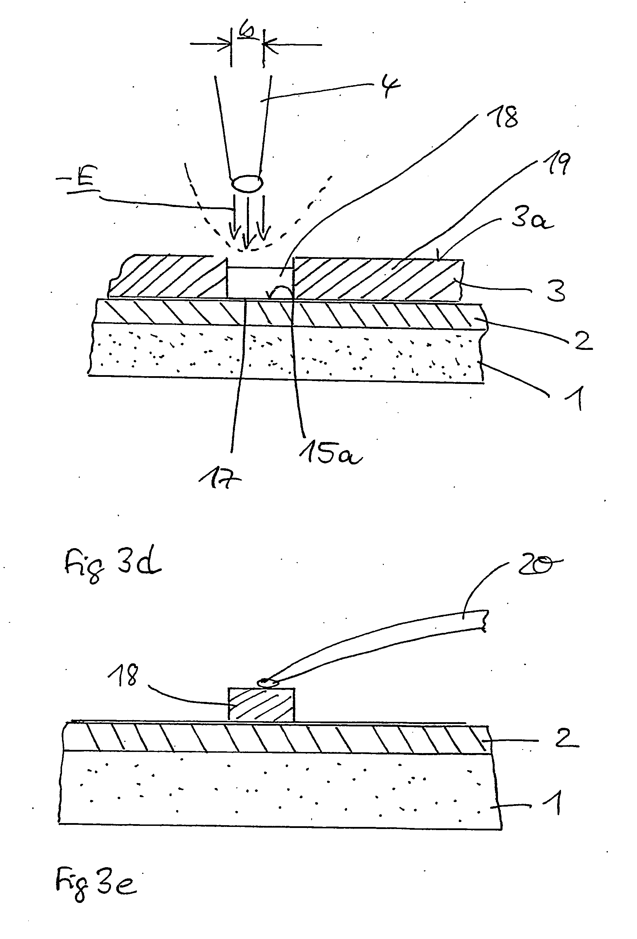

Im Rahmen der Erfindung benutzte Calixarene sind in Fig. 2 anhand des einfachsten Vertreters, des Calix[4]arens, dargestellt. Bei diesen Calixaren sind mit einem tertiären Butylrest versehene Phenolringe zu einer kelchförmigen 3-dimensionalen Struktur verbunden. Erfindungsgemäß werden Calix[n]arene benutzt, die bevorzugt n=4 bis 8 Phenolringe je Molekül enthalten. Wie in Fig. 2 dargestellt ist, sind die einzlenen kelchförmigen Calixarenmoleküle mit der die OH-Gruppen aufweisenden Seite der Phenolringe an der CrAu-Schicht 2 des Substrat 1 gebunden. Diese Bindung ist eine relativ schwache, im wesentlichen über van der Waals-Kräfte erzeugte Bindung. Die tassenartigen Moleküle sind in x-, y- und z-Richtung nach Fign. 3a-e übereinander und nebeneinander ebenfalls über van der Waals-Kräfte unter Beteiligung von Wasserstoffbrückenbindungen zusammengehalten. Die vorherrschenden Bindungsenergien der tassenartigen Molelküle beträgt etwa 0,5 eV.

Erfindungsgemäß wird mit dem Verfahren zur Oberflächenabtragung bzw. mit dem Lithographieverfahren bevorzugt die Calixarenschicht 3 abgetragen bzw. strukturiert, um ggf. weitere Oberflächenbehandlungsmöglichkeiten anzuwenden. Dazu wird nun die Spitze 4 des Cantilevers 5 im non-contact-Modus der Deckschichtoberfläche 3a auf einen Abstand von weniger als 100 nm angenähert. Über die Gleichspannungsquelle 11 wird zwischen CrAu-Schicht 2 eine Gleichspannung von 10 bis 100 V angelegt. Dadurch wird die Calixarenschicht 3 derart polarisiert, daß sich eine negative Ladungsverteilung an den Fußpunkten der in Fig. 3a schematisch dargestellten "Kelche" der Calixarenmoleküle und eine positive Ladungsverteilung an der Seite der Kelche bildet, an der sich die tertiären Reste befinden.

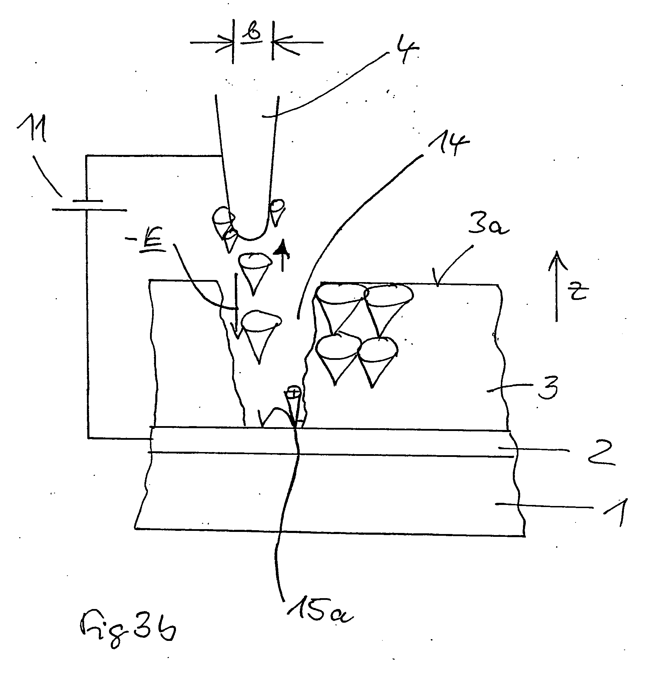

Von der mit der Spannung von der Spannungsquelle 11 beaufschlagten Spitze 4 wird nun eine elektrostatische Anziehungskraft auf den im wesentlichen unter ihr befindlichen Bereich der Deckschicht 3 ausgeübt. Dabei werden einzelne Calixarenmoleküle aus der Deckschicht 3 herausgerissen und zur Spitze 4 gezogen, was in Fig. 3b vereinfacht dargestellt ist. Bei weiterem Verweilen der Spitze über derselben Position der Deckschicht 3 werden nun weitere Moleküle elektrostatisch aus der Deckschicht herausgelöst, so daß eine Vertiefung 14 in der Deckschicht 3 entsteht. Sofern die Spitze 4 lange genug über derselben Position über der Deckschicht 3 gehalten wird, wird bei fortgesetzter elektrostatischer Anziehung von Deckschichtmaterial die Deckschicht an dieser Position vollständig entfernt. Somit liegt dann im Bereich der Vertiefung 14 ein Bereich 15a der CrAu-Schicht 2 frei.

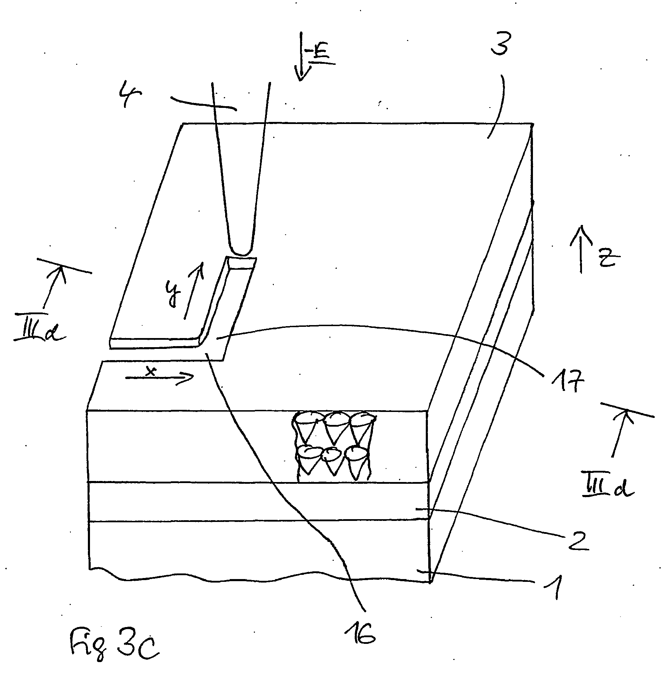

Bei einer Relativ-Bewegung von Spitze 4 und Substrat 1 etwa durch eine Bewegung des Scannertisches 6 in x- und/oder y-Richtung, siehe Fig. 1, kann dann eine linienartige Vertiefung 16 (Fig. 3c) erzeugt werden, sofern die Verweilposition der Spitze 4 über dem jeweiligen Bereich der Deckschicht 3 lang genug ist, um die Deckschicht in z-Richtung vollständig abzulösen.

Die Bewegung des Scannertisches 6 kann erfindungsgemäß dabei so gesteuert werden, daß der Scannertisch 6 einen Verlauf einer oder mehrerLeiterbahnen in einem Schaltungslayout abfährt. An den in der Fig. 3c schematisch angedeuteten, unter der Spitze 4 bewegten linienartigen Bereichen 17 ist keine Deckschicht 3 mehr vorhanden. Wird in einem nachfolgenden Prozeßschritt etwa in einer Aufdampfanlage eine weitere Metallisierungsschicht 18, etwa eine Aluminium-Schicht (Al) aufgedampft, so werden die freigelegten CrAu-Streifen 15a, 17 direkt mit Al bedeckt. Die dabei auch auf den noch mit der Calixaren-Deckschicht 3 bedeckten Bereiche 19 abgeschiedene Al-Schicht wird dann über eine Spülung des Siliziumwafers in einem organischen Lösungsmittel, wie etwa Chloroform. durch ein Lösen der Calixarenschicht 3 entfernt. Auf diese Weise erhält man eine durch die Al-Schicht verstärkte Streifen 18 etwa zum Aufsetzen von Bondingdrähten 20 zur Verbindung aufzubringender externer elektronischer Komponenten.

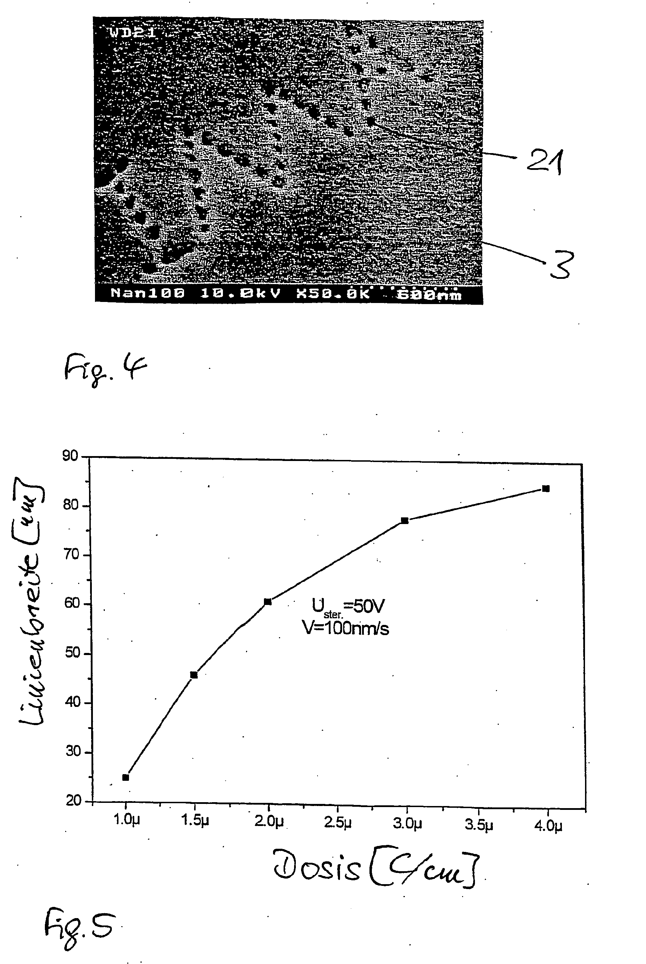

Eine mit dem erfmdungsgemäßen Verfahren strukturierte Calixaren-Oberfläche ist in Form einer rasterelektronischen Aufnahme in Fig. 4 gezeigt. Dabei ist der Bildkontrast so gewählt, daß die Vertiefungen 21 in der Calixarenschicht 3 dunkel/schwarz dargestellt sind.

Bei dem erfindungsgemäßen Verfahren zur Abtragung von Oberflächen bzw. zur Strukturierung von Oberflächen unter Verwendung von Calixarenen wird die elektrostatische Anziehungskraft der positiv geladenen Spitze 4 des Kraftmikroskops auf die an ihrem freien Ende 3a positiv polarisierten Calixarenmoleküle ausgenutzt. Dabei werden die Calixarenmoleküle in einem jeweils unter der Spitze 4 befindlichen Bereich von der Spitze 4 elektrostatisch angezogen und aus der Calixarenschicht 3 herausgerissen. Dabei findet ein Abhebungsprozeß durch die elektrostatische Anziehung bei Überschreiten eines Schwellenwertes der Feldstärke im Bereich von 10⁷ bis 10⁹ V/m statt. Die Verteilung der Feldstärke zwischen der Spitze 4 und dem darunter befindlichen Material ist wie in Fig. 3a bis 3c durch die Pfeile -E angedeutet im wesentlichen nur unterhalb der Spitze 4 ausreichend groß, um die notwendige Energie zum Ausbrechen der Bindung innerhalb der Calixarene bereitzustellen und Material anzuziehen. Dadurch wird über die Breite b der Spitze 4 die bei diesem Lithographieverfahren erreichbare Linienbreite eingestellt bzw. vorgegeben. Die lotrechte Projektion der Spitze 4 auf das Substrat 1 gibt dabei die theoretisch erzielbare kleinste Linienbreite in einfachster Annäherung an.

Mit dem erfindungsgemäßen Verfahren kann durch eine gleichmäßige Relativ-Bewegung von Spitze 4 und Calixarenschicht 3 eine der Bewegung entsprechende Spur 17 in der Calixarenschicht 3 erzeugt werden. Dabei kann sowohl eine teilweise als auch eine vollständige Ablösung der Calixarenschicht 3 in z-Richtung (nach Fig. 3a bis 3e) erreicht werden.

Fig. 5 stellt eine Abhängigkeit der Linienbreite eines aus dem Calixarenmaterial herausgelösten Linienprofils von dem Abstand der Cantileverspitze 4 von der Calixarenschicht 3 dar. Bei der Einstellung eines kleineren Abstands von Spitze 4 und Deckschicht 3 muß der durch die Spitze 4 fließende Strom erhöht werden. Hier ist die durch den Stromfluß durch die Spitze 4 verursachte Feldemission von Elektronen in Form der Dosis in µCoulomb pro Längeneinheit angegeben. Nach Fig. 4 nimmt die Linienbreite mit abnehmendem Abstand von Spitze 4 und Substrat 1 bzw. Calixarenschicht 3 zu. Das entspricht einer in Fig. 3d durch eine gestrichelte Linie gezeigten Einhüllenden der Feldlinien -E des elektrischen Feldes mit einer für die Ablösung von Material ausreichenden Feldstärke. Umso näher die Spitze 4 sich über dem Substrat 1 befindet, umso kleiner ist der von den Äquipotentialflächen zur Ablösung gerade noch ausreichenden elektrostatischen Potentials durchsetzte Abschnitt der Deckschichtoberfläche 3a. Die Äquipotentialflächen sind dabei in erster Näherung die Spitze 4 umgebende Paraboloide. Die Spitze 4 des atomaren Kraftmikroskops muß erfindungsgemäß derart gestaltet sein, daß ein enorm hohes Aspektverhältnis, der Quotient aus Höhe und Breite bzw. Durchmesser der Spitze 4 erreicht wird. Dazu weist die zur Durchführung des erfindungsgemäßen Verfahrens eingesetzte Spitze 4 bei einem Durchmesser von etwa 2 bis 10 nm eine Höhe von 200 bis 300 nm auf. Der Krümmungsradius ist am unteren Ende der Spitze 4 etwa 20 nm.

Erfindungsgemäß ist ein wichtiger Parameter für die erreichbaren Strukturen neben der Feldstärke die Bewegungsgeschwindigkeit der Spitze 4 über und relativ zu dem Substrat 1. Die Geschwindigkeit der Spitze 4 kann dabei erfindungsgemäß zwischen 10 nm/sec bis 100 µm/sec variiert werden. Sofern eine grobe Struktur geschrieben werden soll, kann die Spitze mit einer Geschwindigkeit aus dem oberen Bereich dieses Geschwindigkeitsintervalls bewegt werden, im Falle einer sehr kleinen zu schreibenden Struktur mit Breiten von einigen wenigen Nanometern ist die Geschwindigkeit der Spitze 4 eher am unteren Ende des vorbezeichneten Geschwindigkeitsintervalls einzustellen. Dabei nimmt sowohl die laterale Schärfe der abgetragenen Strukturen als auch die Tiefe der geschriebenen Strukturen mit einer Erhöhung der Geschwindigkeit ab. Bei Überschreiten einer bestimmten Geschwindigkeit von größer 1µm/s wird die Spitze 4 so schnell relativ zu der abzutragenden Schicht 3 bewegt, daß ein Oberflächenabtrag kaum noch zu verzeichnen ist.

Erfindungsgemäß muß die Spitze 4 nach einer gewissen Schreibdauer d.h. nach einer Entfernung eines Materials etwa entlang eines Streifens über der zu strukturierenden bzw. abzutragenden Calixarenschicht 3 eine Stopp-Position außerhalb des zu strukturierenden Bereiches gebracht werden, um dort durch einen Ablösevorgang von an der Spitze 4 angesammeltem Calixarenmaterial durchzuführen. Damit wird vermieden, daß insbesondere bei einer geringen Bewegungsgeschwindigkeit der Spitze 4, d.h. insbesondere bei einem quasi-stationären Betrieb der Spitze 4 aus der Calixarenschicht 3 herausgelöstes Material sich nicht von der Spitze 4 löst und wieder zurück auf die bereits aus der Calixarenschicht 3 herausgelösten Bereiche 17 fällt und diese nicht wieder ganz oder teilweise wieder bedeckt. Abhängig von der Bewegungsgeschwindigkeit und den elektrischen Parametern wie Spannung und Strom an bzw. durch die Spitze 4 ist eine Entfernung der Ablagerungen an der Spitze 4 unterschiedlich oft durchzuführen.

Die Erfindung ist nicht auf das beschriebene Ausführungsbeispiel beschränkt, das in vielfacher Art und Weise modifizierbar ist. So kann auch eine Oberfläche 1a eines Substrates 1 strukturiert werden, welches zumindest an der Oberfläche 1a aus Molekülen mit einer begrenzten räumlichen Ausdehnung gebildet ist, die untereinander durch schwache zwischenmolekulare Kräfte gebunden sind. Auch ist es möglich ein Substrat 1 zu verwenden, das insgesamt aus räumlich begrenzten durch schwache Kräfte gebundenen Molekülen gebildet ist. Eine an der Oberfläche 1a des Substrats 1 vorgesehene, strukturierbare Deckschicht 3 kann auch aus einem anderen als dem beschriebenen Material gebildet sein, dessen Moleküle mit einer schwachen Bindung, miteinander verbunden sind. Die Deckschicht 3 kann auch etwa durch van der Waals-Kräfte auf einer darunter liegenden Schicht des Substrats 1 gebunden sein. Es sind solche Materialien, vorzugsweise organische Materialien, verwendbar, die sich so auf ein Substrat 1 aufbringen lassen, daß eine 3-dimensional regelmäßige Anordnung ihrer Moleküle entsteht.

Ebenso kann die Deckschicht 3 auch anders als beschrieben aufgebracht werden. So ist es im Rahmen der Erfindung auch vorgesehen, die Deckschicht 3 über die Langmuir-Blodgett-Technologie aufzubringen. Dabei entsteht eine molekular regelmäßig geordnete Schichtstruktur aus mehreren übereinander angeordneten Monolagen. Auch sind weitere bei Herstellung und Ablagerung bzw. Abscheidung von dünnen Filmen bekannte Verfahren zum Aufbringen der dünnfilmartigen Deckschicht 3 möglich.

Ferner kann die zur Materialabtragung benutzte Spitze 4 eine herkömmliche in der Kraftfeldmikroskopie eingesetzte Spitze 4 sein. Als Substratmaterialien sind neben Halbleitermaterialien auch andere Festkörper einsetzbar. Bei der Durchführung des erfindungsgemäßen Verfahrens kann auch das Substrat 1 ortsfest gehalten werden und der Cantilever 5 darüber bewegt werden.

Ferner ist es in weiteren Ausführungen der Erfindung ebenso möglich, die Gleichspannungsquelle 11 mit den zur Abstandsmessung bzw. -einstellung des Cantilevers von der Oberfläche 3a benutzten elektrischen Komponenten 7, 8 zu kombinieren. Auch ist es vorgesehen anstelle des piezoresistiven Kraftsensors in dem Cantilever 5 zur Einstellung des Abstands von der Oberfläche eine Laseroptik verwendet werden kann.

Ebenso ist das erfindungsgemäße Verfahren mit zahlreichen in der Mikro- bzw. Nanostrukturtechnik bekannten Prozeßschritten wie Ionenimplantation, naßchemisches Ätzen, Trockenätzen, thermische Oxidationsverfahren, Aufbringen von Metallisierungsschichten sowie anderen 2- oder 3-dimensionalen Markierungsverfahren kombinierbar.

## Patentansprüche

1. Verfahren zur elektrostatischen Strukturierung einer Substratoberfläche (1a) durch Positionieren einer an einem Biegebalken (5) eines atomaren Kraftmikroskops angebrachten Spitze (4) über dem Substrat (1), wobei zwischen dem Substrat (1) und der Spitze (4) eine elektrische Gleichspannung angelegt wird, wobei der Abstand der Spitze (4) von dem Substrat (1) und die Gleichspannung so gewählt werden, daß in einem im wesentlichen unterhalb der Spitze (4) befindlichen Bereich (17) des Substrats (1) Substratmaterial von der Spitze (4) elektrostatisch angezogen wird, und das Substrat (17) an der Substratoberfläche (1a) dadurch zumindest teilweise abgetragen wird, **dadurch gekennzeichnet, daß** ein Substrat (1) mit einer Oberfläche (1 a) verwendet wird, die von einer Deckschicht (3) aus Molekülen mit einer kelchförmigen 3-dimensionalen Struktur gebildet ist, die untereinander im wesentlichen durch van der Waals-Kräfte gebunden sind, wobei als Deckschicht (3) ein Calixarene enthaltendes Material gewählt wird.

2. Verfahren nach Anspruch 1, **dadurch gekennzeichnet, daß** die Struktur der Moleküle über Wasserstoffbrückenbindungen stabilisiert wird.

3. Verfahren nach Anspruch 1 oder 2, **dadurch gekennzeichnet, daß** eine Vertiefung (14, 16) erzeugt wird, deren Größe durch eine Veränderung des Abstands d von Spitze (4) und Substrat (1) eingestellt wird.

4. Verfahren nach Anspruch 3, **dadurch gekennzeichnet, daß** der Abstand d und die Gleichspannung so gewählt werden, daß die Vertiefung (14, 16) einen Querschnitt erhält, der im wesentlichen dem Querschnitt der Spitze (4) entspricht.

5. Verfahren nach Anspruch 3 oder 4, **dadurch gekennzeichnet, daß** durch eine lineare Relativbewegung zwischen der Spitze (4) und dem Substrat (3) eine linienartige Vertiefung (16) erzeugt wird.

6. Verfahren nach Anspruch 5, **dadurch gekennzeichnet, daß** die Vertiefung (14, 16) mit Unterbrechungen erzeugt wird.

7. Verfahren nach einem der Ansprüche 1 bis 6, **dadurch gekennzeichnet, daß** das Substrat (1) wenigstens teilweise aus einem elektrisch leitenden Material gebildet wird.

8. Verfahren nach einem der Ansprüche 1 bis 7, **dadurch gekennzeichnet, daß** das Substrat (1) mit einer elektrisch leitenden Schicht (2) versehen wird.

9. Verfahren nach Anspruch 8, **dadurch gekennzeichnet, daß** die Gleichspannung zwischen der elektrisch leitenden Schicht (2) und der Spitze (4) angelegt wird.

10. Verfahren nach einem der Ansprüche 1 bis 9, **dadurch gekennzeichnet, daß** die Relativbewegung zwischen der Spitze (4) und dem Substrat (1) mit einer veränderlichen Geschwindigkeit durchgeführt wird.

11. Verfahren nach einem der Ansprüche 1 bis 10, **dadurch gekennzeichnet, daß** das Substrat (1) relativ zu der feststehenden Spitze (4) bewegt wird.

12. Verfahren nach einem der Ansprüche 1 bis 10, **dadurch gekennzeichnet, daß** die Spitze (4) relativ zu dem feststehenden Substrat (1) bewegt wird.

13. Verfahren nach einem der Ansprüche 1 bis 12, **dadurch gekennzeichnet, daß** ein Substrat verwendet wird, das mehrere Schichten (1, 2, 3) aufweist.

14. Verfahren nach einem der Ansprüche 1 bis 13, **dadurch gekennzeichnet, daß** in einem Deckschichtbereich (17) Deckschichtmaterial von der Spitze (4) angezogen wird.

15. Verfahren nach einem der Ansprüche 1 bis 14, **dadurch gekennzeichnet, daß** die Deckschicht (3) aus Molekülen mit begrenzter Ausdehnung gebildet ist, und daß die Moleküle untereinander und an einer darunter liegenden Schicht (2) des Substrats (1) im wesentlichen durch van der Waals-Kräfte gebunden sind.

16. Verfahren nach einem der Ansprüche 1 bis 15, **dadurch gekennzeichnet, daß** die Moleküle der Deckschicht (3) an der darunter liegenden Schicht (2) des Substrates (1) teilweise durch Wasserstoffbrückenbindungen gehalten werden.

17. Verfahren nach einem der Ansprüche 1 bis 16, **dadurch gekennzeichnet, daß** das Deckschichtmaterial des Deckschichtbereichs (17) ohne eine physikalische Zustandsänderung zu durchlaufen herausgelöst wird.

18. Verfahren nach einem der Ansprüche 1 bis 17, **dadurch gekennzeichnet, daß** das Deckschichtmaterial so herausgelöst wird, daß die Vertiefung (14, 16) die Deckschicht (3) vollständig durchsetzt.

19. Rastersonden-Lithographieverfahren, wobei eine Deckschicht (3) aus einem Calixarene enthaltenden Material auf eine Oberfläche (1 a) eines Substrats (1) aufgebracht wird, wobei die Substratoberfläche (1a) mit einem Verfahren nach einem der Ansprüche 1 bis 18 teilweise strukturiert wird, wobei ein Bereich (15a) der Substratoberfläche (1a) durch Abtragen der Deckschicht (3) freigelegt wird, und wobei der freigelegte Beeich (15a) einer Oberflächenbehandlung in Form eines selektiven Abtragens oder eines Aufbringens zumindest einer weiteren Schicht (18) unterzogen wird.

20. Verfahren nach Anspruch 19, **gekennzeichnet durch** ein Erzeugen von Oberflächenstrukturen **durch** eine Relativ-Bewegung von Sonde (4) und Substrat (1) zumindest in einer zu der Oberfläche (1a) parallelen Ebene.

## Claims

1. Method for electrostatically patterning a substrate surface (1a) by positioning a tip (4) fitted to a bending beam (5) of an atomic force microscope above the substrate (1), wherein an electrical DC voltage is applied between the substrate (1) and the tip (4), wherein the distance between the tip (4) and the substrate (1) and the DC voltage are chosen such that, in a region (17) of the substrate (1) situated substantially below the tip (4) substrate material is electrostatically attracted by the tip (4), and the substrate (17) is thereby at least partly removed at the substrate surface (1a), **characterized in that** use is made of a substrate (1) having a surface (1a) which is formed by a cover layer (3) composed of molecules having a cup-shaped 3-dimensional structure which are bonded among one another substantially by van der Waals forces, wherein a calixarene-containing material is chosen as cover layer (3).

2. Method according to Claim 1, **characterized in that** the structure of the molecules is stabilized by means of hydrogen bridge bonds.

3. Method according to Claim 1 or 2, **characterized in that** a depression (14, 16) is produced, the size of which is set by an alteration of the distance d between tip (4) and substrate (1).

4. Method according to Claim 3, **characterized in that** the distance d and the DC voltage are chosen such that the depression (14, 16) acquires a cross section substantially corresponding to the cross section of the tip (4).

5. Method according to Claim 3 or 4, **characterized in that** a line-like depression (16) is produced by a linear relative movement between the tip (4) and the substrate (3).

6. Method according to Claim 5, **characterized in that** the depression (14, 16) is produced with interruptions.

7. Method according to any of Claims 1 to 6, **characterized in that** the substrate (1) is formed at least partly from an electrically conductive material.

8. Method according to any of Claims 1 to 7, **characterized in that** the substrate (1) is provided with an electrically conductive layer (2).

9. Method according to Claim 8, **characterized in that** the DC voltage is applied between the electrically conductive layer (2) and the tip (4).

10. Method according to any of Claims 1 to 9, **characterized in that** the relative movement between the tip (4) and the substrate (1) is carried out with a variable speed.

11. Method according to any of Claims 1 to 10, **characterized in that** the substrate (1) is moved relative to the stationary tip (4).

12. Method according to any of Claims 1 to 10, **characterized in that** the tip (4) is moved relative to the stationary substrate (1).

13. Method according to any of Claims 1 to 12, **characterized in that** a substrate is used which has a plurality of layers (1, 2, 3).

14. Method according to any of Claims 1 to 13, **characterized in that** cover layer material is attracted by the tip (4) in a cover layer region (17).

15. Method according to any of Claims 1 to 14, **characterized in that** the cover layer (3) is formed from molecules having a limited extent, and **in that** the molecules are bonded among one another and to an underlying layer (2) of the substrate (1) substantially by van der Waals forces.

16. Method according to any of Claims 1 to 15, **characterized in that** the molecules of the cover layer (3) are held on the underlying layer (2) of the substrate (1) partly by hydrogen bridge bonds.

17. Method according to any of Claims 1 to 16, **characterized in that** the cover layer material of the cover layer region (17) is extracted without undergoing a physical state change.

18. Method according to any of Claims 1 to 17, **characterized in that** the cover layer material is extracted in such a way that the depression (14, 16) completely penetrates through the cover layer (3).

19. Scanning probe lithography method, wherein a cover layer (3) composed of a calixarene-containing material is applied to a surface (1a) of a substrate (1), wherein the substrate surface (1a) is partly patterned by a method according to any of Claims 1 to 18, wherein a region (15a) of the substrate surface (1a) is uncovered by the removal of the cover layer (3), and wherein the uncovered region (15a) is subjected to a surface treatment in the form of selective removal or application of at least one further layer (18).

20. Method according to Claim 19, **characterized by** producing surface structures by means of a relative movement of probe (4) and substrate (1) at least in a plane parallel to the surface (1a).

## Revendications

1. Procédé de structuration électrostatique d'une surface de substrat (1a) en positionnant au-dessus du substrat (1) une pointe (4) appliquée au niveau d'une tige flexible (5) d'un microscope à force atomique, sachant qu'une tension continue électrique est appliquée entre le substrat (1) et la pointe (4), sachant que la distance entre la pointe (4) et le substrat (1) ainsi que la tension continue sont choisies de telle manière que le matériau du substrat est attiré de manière électrostatique par la pointe (4) dans une zone (17) du substrat (1) se trouvant essentiellement sous la pointe (4), ce qui a pour conséquence d'enlever au moins partiellement le substrat (17) au niveau de la surface du substrat (1a), **caractérisé en ce qu'**on utilise un substrat (1) avec une surface (1a) qui est formée par une couche de recouvrement (3) constituée de molécules, lesquelles présentent une structure tridimensionnelle en forme de coupe et sont liées entre elles essentiellement par des forces de van der Waals, sachant qu'on choisit comme couche de recouvrement (3) un matériau contenant du calixarène.

2. Procédé selon la revendication 1, **caractérisé en ce que** la structure des molécules est stabilisée par l'intermédiaire de liaisons pont hydrogène.

3. Procédé selon la revendication 1 ou 2, **caractérisé en ce qu'**un creux (14, 16) est obtenu, dont la dimension est ajustée par une modification de la distance d entre la pointe (4) et le substrat (1).

4. Procédé selon la revendication 3, **caractérisé en ce que** la distance d et la tension continue sont choisies de telle manière que le creux (14, 16) contient une section transversale qui correspond essentiellement à la section transversale de la pointe (4).

5. Procédé selon la revendication 3 ou 4, **caractérisé en ce qu'**un creux (16) linéaire est obtenu par un déplacement relatif linéaire entre la pointe (4) et le substrat (3).

6. Procédé selon la revendication 5, **caractérisé en ce que** le creux (14, 16) est obtenu avec des discontinuités.

7. Procédé selon l'une quelconque des revendications 1 à 6, **caractérisé en ce que** le substrat (1) est formé au moins partiellement à partir d'un matériau électriquement conducteur.

8. Procédé selon l'une quelconque des revendications 1 à 7, **caractérisé en ce que** le substrat (1) est pourvu d'une couche (2) électriquement conductrice.

9. Procédé selon la revendication 8, **caractérisé en ce que** la tension continue est appliquée entre la couche (2) électriquement conductrice et la pointe (4).

10. Procédé selon l'une quelconque des revendications 1 à 9, **caractérisé en ce que** le déplacement relatif entre la pointe (4) et le substrat (1) est exécuté avec une vitesse variable.

11. Procédé selon l'une quelconque des revendications 1 à 10, **caractérisé en ce que** le substrat (1) est déplacé par rapport à la pointe (4) immobile.

12. Procédé selon l'une quelconque des revendications 1 à 10, **caractérisé en ce que** la pointe (4) est déplacée par rapport au substrat (1) immobile.

13. Procédé selon l'une quelconque des revendications 1 à 12, **caractérisé en ce qu'**on utilise un substrat qui présente plusieurs couches (1, 2, 3).

14. Procédé selon l'une quelconque des revendications 1 à 13, **caractérisé en ce que** du matériau de la couche de recouvrement est attiré par la pointe (4) dans une zone de la couche de recouvrement (17).

15. Procédé selon l'une quelconque des revendications 1 à 14, **caractérisé en ce que** la couche de recouvrement (3) est formée à partir de molécules présentant une expansion limitée, et **en ce que** les molécules sont liées entre elles et au niveau d'une couche (2) du substrat (1) se trouvant en-dessous essentiellement par des forces de van der Waals.

16. Procédé selon l'une quelconque des revendications 1 à 15, **caractérisé en ce que** les molécules de la couche de recouvrement (3) sont maintenues au niveau de la couche (2) du substrat (1) se trouvant en-dessous partiellement par des liaisons pont hydrogène.

17. Procédé selon l'une quelconque des revendications 1 à 16, **caractérisé en ce que** du matériau de la couche de recouvrement de la zone de la couche de recouvrement (17) est éliminé sans avoir à effectuer une modification physique de l'état.

18. Procédé selon l'une quelconque des revendications 1 à 17, **caractérisé en ce que** le matériau de la couche de recouvrement est éliminé de telle manière que le creux (14, 16) traverse complètement la couche de recouvrement (3).

19. Procédé lithographique à sondes à balayage, sachant qu'une couche de recouvrement (3) constituée d'un matériau contenant du calixarène est appliquée sur une surface (1a) d'un substrat (1), sachant que la surface du substrat (1a) est structurée avec un procédé selon l'une quelconque des revendications 1 à 18, sachant qu'une zone (15a) de la surface du substrat (1a) est dégagée par enlèvement de la couche de recouvrement (3) et sachant que la zone dégagée (15a) est soumise à un traitement de surface sous la forme d'un enlèvement sélectif ou d'une application au moins d'une autre couche (18).

20. Procédé selon la revendication 19, **caractérisé par** l'obtention de structures de surface par un déplacement relatif de la sonde (4) et du substrat (1) au moins dans un plan parallèle à la surface (1a).
